# EUROPEAN PATENT APPLICATION

(11) **EP 0 916 745 A1**
(43) Date of publication of application: **19.05.1999**
(21) Application number: 98203644.4
(22) Date of filing: 28.10.1998
(51) Int. Cl.: C23C 16/00, C30B 25/18

(54) **Two piece diamond deposition mandrel having graphite ring**

(30) Priority: 04.11.1997 US 963919
(71) Applicant: Saint-Gobain Industrial Ceramics, Inc., Worcester, MA 01615-0138 (US)
(72) Inventor: Martin, Scott D., Paxton, MA 01612 (US); Foye, Bruce E., Pembroke, NH 03275 (US)
(74) Representative: Richebourg, Michel François

(57) **Abstract**

A mandrel for making a free standing diamond includes a TiN coated molybdenum component and a graphite component. In a first embodiment for forming a free-standing diamond film, the molybdenum component has a stepped solid cylindrical shape with a central plateau having a side wall. The graphite ring is provided around the plateau, and has an upper surface which is generally coplanar with the plateau. The diamond film grows across the TiN coated molybdenum component and the graphite ring. According to a preferred aspect of the invention, the graphite ring is affixed about the plateau of the first component by thermal expansion between the molybdenum and the graphite ring during the CVD process. In a second embodiment, a graphite component is provided with a recessed portion which receives a TiN coated molybdenum plug. The graphite component and plug form a generally planar surface. The diamond is coated across the plug and the graphite. In each embodiment, the different coefficients of thermal expansion of the diamond film, the molybdenum, and the graphite, the molybdenum tends to contract under the diamond and separate from the diamond film. The graphite portion has increased diamond adhesion properties and causes the diamond to crack in a controlled manner at the boundary of the graphite and TiN coated molybdenum, preventing the film from shattering and resulting in a razor clean break in the diamond film around its perimeter.

## Description

This application is related to co-owned U.S. Serial No. 08/388,788, filed on February 15, 1995, which is hereby incorporated by reference herein in its entirety.

The present invention was made with Government support, and the Government has certain rights in the invention.

### BACKGROUND OF THE INVENTION

### 1. Field of the Invention

This invention relates broadly to diamond film manufacturing. More particularly, this invention relates to an apparatus and method for manufacturing free standing diamond films.

### 2. State of the Art

Diamond has exceptional hardness, thermal conductivity, electrical insulation and light transmission properties, and is therefore useful in various applications such as cutting tools, heat sinks, insulators, electronic substrate materials, etc.
Natural diamond, however, is monocrystalline and limited in size and geometry. As a result, a number of techniques have recently been developed, such as high pressure high temperature deposition (HPHT) and chemical vapor deposition (CVD), for synthesizing and depositing synthetically-made diamond on substrates of various shapes, sizes and materials. The below discussion relates to CVD diamond film deposition.

Synthetic CVD diamond film can be deposited as a thin permanent coating on a substrate, such as on the wear surface of a tool or as an environmentally protective coating. Such films are generally referred to as thin films.
Alternatively, a thicker diamond film can be deposited on a substrate and then removed, preferably intact, as a single "free standing" piece for use in applications such as heat sinks, optical windows, and cutting tools. These free standing pieces are usually referred to as thick films.

In the manufacture of thick films, it is convenient to deposit the diamond on a substrate and then allow thermal stresses during cooling to detach the diamond from the substrate. This process eliminates the operation of removing the diamond from the substrate, and allows the substrate to be reused. In general, several considerations must be taken into account when manufacturing free standing diamond films by depositing synthetic diamond on a substrate. A relatively weak bond between the diamond and substrate is essential to ensure that the diamond will easily detach from the substrate. The substrate material and diamond generally have different coefficients of expansion, as well as different molecular and chemical structures, which affects the growth, adhesion, and smoothness of the diamond film. Other factors, such as surface preparation, and deposition parameters will also affect the growth and adherence of the synthetic diamond on the substrate.

Titanium nitride coated molybdenum and other materials having similar properties, such as titanium-zirconium-molybdenum alloys and tungsten, have traditionally been used as a substrate (mandrel) upon which synthetic diamond is to be deposited. These materials are chosen because of their temperature properties including coefficients of expansion, and their machinability. A layer of synthetic diamond can be deposited on a TiN coated molybdenum substrate, such as by CVD, and then released from the substrate after the desired thickness of diamond film is reached. The diamond is deposited on the substrate at a relatively high temperature and, as the diamond and the substrate cool after completion of the diamond deposition, the diamond is released from the substrate as a result of the difference in the coefficient of thermal expansion of the diamond and the substrate materials. Since the outer edges of the substrate cool faster than the inner portions of the substrate, several problems may arise during this procedure. Diamond film may detach or lift from the substrate prematurely (e.g., during deposition or cool down), resulting in an incomplete and defective diamond film. Often the premature lifting also causes the diamond wafer to shatter into several pieces. Furthermore, even upon properly timed release of the diamond film from the substrate after deposition, the diamond film tends to crack at the edges and/or break.

One approach to minimize the lifting problems is described in U.S. Serial No. 08/388,788, previously incorporated herein, where a band of exposed molybdenum is provided on the mandrel; i.e., a band of the TiN coating is removed to expose the underlying molybdenum substrate. Diamond is then deposited and adheres to the molybdenum and, in many cases, the diamond film is prevented from premature lifting. However, even with this improvement, during cool down the diamond film is still subject to shattering along its edges adjacent the exposed band, with portions of the film remaining stuck on the mandrel at the band. Furthermore, the exposed molybdenum band does not always prevent lifting.

### SUMMARY OF THE INVENTION

It is therefore an object of the invention to provide a substrate and method for making a free standing diamond film.

It is also an object of the invention to provide a substrate and method for making a free standing diamond film which allows for the more reliable and easy removal of the diamond film from the substrate.

It is a further object of the invention to provide a substrate for making a free standing diamond film which prevents the diamond film from releasing prematurely from the substrate while diamond is being deposited on the apparatus.

It is also an object of the invention to provide a substrate which reduces the cracking/breaking of a diamond film when the diamond releases and is subsequently removed from the substrate.

In accordance with the objects of the invention, which will be discussed in detail below, a two piece mandrel is provided in which a first component has a surface with different diamond adhesion properties than a surface of a second component which surrounds the first component. In general, the second component has a surface which has greater diamond adhesion properties.

In a first embodiment of the invention for forming a free-standing diamond film, a first component of the mandrel includes a titanium nitride (TiN) coated molybdenum (Mo) substrate having a stepped solid cylindrical shape with a central plateau having a side wall, or flank. The second component is a graphite ring which is provided around the plateau and has an upper surface which is generally coplanar with the plateau. The diamond film grows across the TiN coated molybdenum first component and the graphite ring second component. According to a preferred aspect of the invention, the graphite ring is affixed about the plateau of the first component by thermal expansion between the molybdenum and the graphite ring during the CVD process.

In a second embodiment of the invention, a first graphite component is provided with a recess which receives a TiN coated molybdenum plug. The graphite component and plug together form a generally planar surface. The diamond is coated across the plug and the graphite, with the materials performing relatively the same function as in the first embodiment.

In accord with the invention, the diamond adhesion properties of the mandrel substrate are influenced by the nature of the material on which the diamond film is deposited and by the relative roughness of the mandrel surface. The graphite has greater diamond adhesion properties than TiN. Therefore, the graphite prevents the film from lifting during cool down and has also experimentally been shown to prevent the film from shattering.

According to the method of the invention, which relates closely to the two piece mandrel, a diamond film is deposited on the two piece mandrel of the invention until a desired diamond film thickness is achieved. The mandrel and the diamond film are then cooled. Due to the different coefficients of thermal expansion of the diamond film, the molybdenum, and the graphite, the molybdenum tends to contract under the diamond and separate from the diamond film. The graphite portion has increased diamond adhesion properties and causes the diamond to crack in a controlled manner at the boundary of the more adherent and less adherent portions of the mandrel. This prevents the film from shattering, and results in a razor clean break in the diamond film around its perimeter.

Additional objects and advantages of the invention will become apparent to those skilled in the art upon reference to the detailed description taken in conjunction with the provided figures.

### BRIEF DESCRIPTION OF THE DRAWINGS

Figure 1 is a schematic perspective view of a first embodiment of a mandrel according to the invention;
Figure 2 is a cross-section through line 2-2 in Figure 1;
Figures 3 through 5 illustrate the removal of a diamond wafer from the first embodiment of the mandrel of the invention;
Figure 6 is a schematic perspective view of a second embodiment of a mandrel according to the invention; and
Figure 7 is a cross-section through line 7-7 in Figure 6.

### DETAILED DESCRIPTION OF THE PREFERRED EMBODIMENT

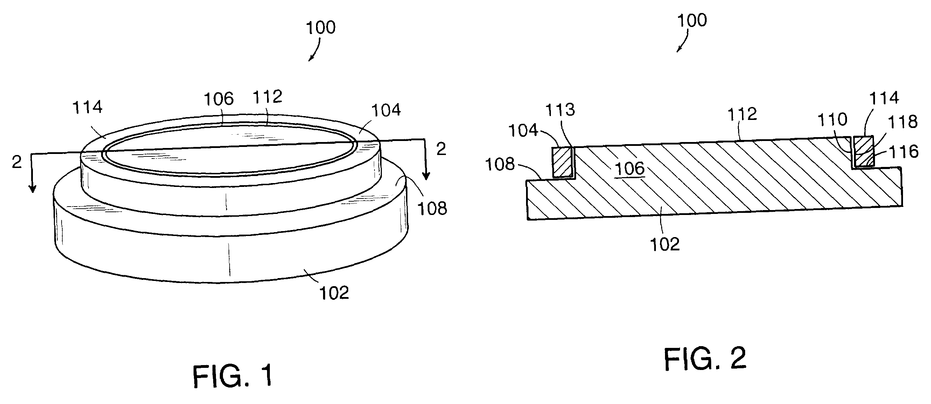

Turning now to Figures 1 and 2, a first embodiment of the mandrel 100 of the invention is shown. The mandrel 100 generally includes a base 102 and a graphite ring 104. The base 102 comprises a titanium nitride (TiN) coated molybdenum (Mo) substrate. The thickness of the TiN coating is preferably in the 0.2 to 2 microns range. The TiN coated Mo substrate has a stepped solid cylindrical shape with a central plateau 106 and a shoulder 108. The central plateau 106 further includes a side wall or flank 110 having a height of approximately 0.250" (6 mm), and a circular top surface 112 having a diameter of approximately 3-4.5" (75-113 mm). Preferably, the 90° corner 113 formed between the flank 110 and the top surface 112 is broken prior to the base being coated with TiN; i.e., the sharp edge is removed in order to expedite placement of the graphite ring 104 around the central plateau 106. The graphite ring 104 has an upper surface 114, a lower surface 116, an inner surface 118, and an outer surface 120. Preferably graphite ring is coated with silicon carbide base paint on its exposed surfaces (upper surface 114 and outer surface 120) for protection in the deposition environment. The height of the graphite ring 104 is preferably approximately 0.251" (6 mm); i.e., 0.001 inches higher than the height of the side wall 110 of the plateau 106. The thickness of the graphite ring 104 is preferably approximately 0.150-0.750", and more preferably approximately 0.250". The diameter across the inner surface 118 of the graphite ring 104 is approximately 0.001-0.005" greater in diameter than the diameter of the top surface 112 of the plateau 106, and most preferably 0.001 inches greater. As such, the graphite ring 104 may be placed around the plateau 106, or removed from around the plateau, when the mandrel is in a cooled state (both components at room temperature) and will be secured around the plateau by an interference fit during use due to the thermal expansion of the molybdenum and the graphite.

The graphite ring 104 is placed around the plateau 106 of the base 102 such that the lower surface 116 of the graphite ring 104 rests upon the shoulder 108 of the base 102. The upper surface 114 of the graphite ring 104 is substantially coplanar (i.e., 0.001" higher) with the top surface 112 of the TiN coated molybdenum base 102. The top surface 112 of the plateau 106 forms a first surface for receiving a CVD diamond film, while the upper surface 114 of the graphite ring 104 forms a second surface for receiving a CVD diamond film. The base 102 below the shoulder 108 has a diameter of approximately 7" (175 mm) and is preferably attached to a rotating cooling device.

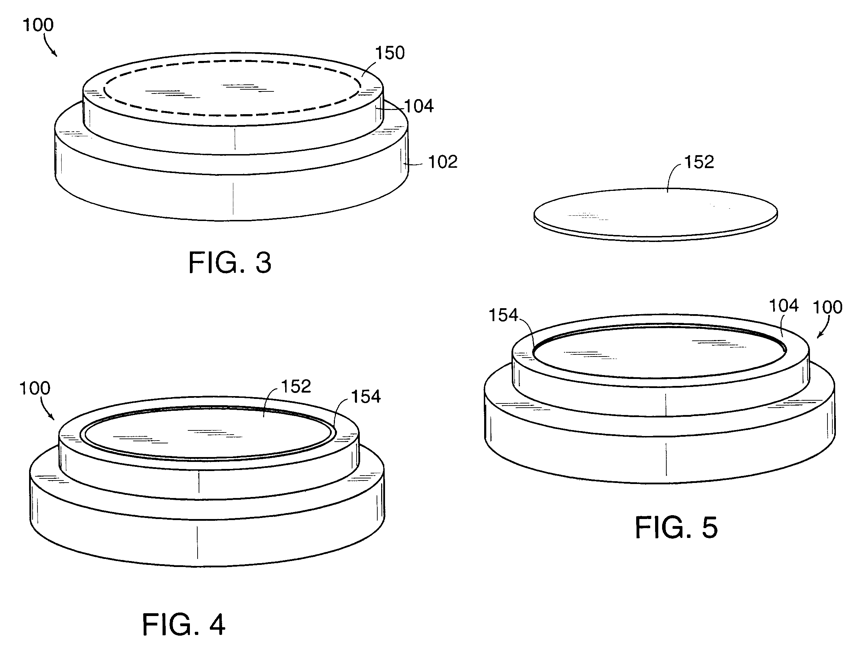

A diamond film is deposited on the first and second diamond film receiving surfaces 112, 114 of the mandrel until a desired diamond film thickness is achieved. Referring to Figures 3 through 5, the mandrel 100 and the diamond film 150 (shown in hatching) are then cooled. Due to the different coefficients of thermal expansion of the diamond film, the molybdenum, and the graphite, the molybdenum tends to contract under the diamond and separate from the diamond film. The graphite portion 104 has increased diamond adhesion properties and, as a result, the diamond tends to crack in a controlled manner at the boundary 154 of the more adherent and less adherent portions of the mandrel. This prevents the film from shattering and results in a diamond wafer 152 which is easily removed from the mandrel and has a razor clean break around its perimeter.

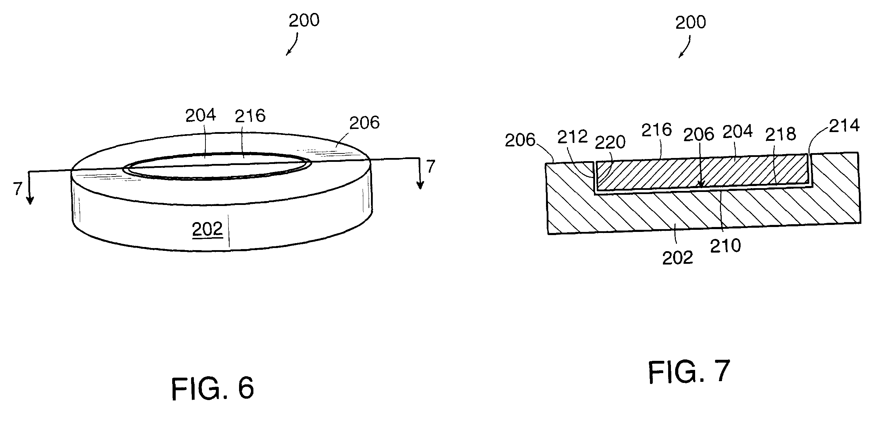

Figures 6 and 7 show a second embodiment of the mandrel 200 of the invention. In the second embodiment, functioning similarly to the first embodiment, the mandrel 200 generally includes a graphite base 202 and a TiN coated molybdenum plug 204. The graphite base 202 is preferably generally cylindrical in shape, with an outer surface 205, an upper surface 206, and a central recess 208 having a floor 210 and a wall 212. Preferably graphite base 202 is coated with silicon carbide base paint on its exposed surfaces (outer surface 205 and upper surface 206) for protection in the deposition environment. The wall 212 has a height of approximately 0.250" (6 mm), and the floor 210 has a diameter of approximately 3-4.5" (75-113 mm). The upper surface surrounding the wall has a radial thickness of approximately 0.5". Preferably, the 90° corner 214 formed between the upper surface 206 and the wall 212 is broken; i.e., the sharp edge is removed to expedite fitting the plug in the base. The plug 204 is preferably disc shaped, and has an upper surface 216, a lower surface 218, and a peripheral wall 220. The height of the peripheral wall 220 is preferably approximately 0.249" (6 mm); i.e., 0.001 inches lower than the height of the wall 212 forming the recess 208. The diameter of the plug 204 is approximately 3-4.5", and preferably at least 0.001" smaller than the diameter of the floor 210. As such, the TiN coated molybdenum plug 204 may be seated in the recess when the mandrel is in a cooled state (both base 202 and plug 204 at room temperature) and will be secured within the recess by an interference fit during use due to the thermal expansion of the molybdenum and the graphite.

As with the first embodiment, the graphite base and TiN coated molybdenum plug assemble into a mandrel which has an inner upper surface with a TiN coated molybdenum central portion and a outer upper graphite surface. It will be appreciated that there may be other ways of forming a mandrel having an upper surface with a TiN coated molybdenum central surface and a surrounding graphite surface, and all other such embodiment are within the scope of this invention.

There have been described and illustrated herein several embodiments of a method and apparatus for manufacturing free standing diamond films. While particular embodiments of the invention have been described, it is not intended that the invention be limited thereto, as it is intended that the invention be as broad in scope as the art will allow and that the specification be read likewise. Thus, while particular mandrel shapes have been disclosed, it will be appreciated that other mandrels may be used as well. While a generally stepped cylindrical mandrel has been disclosed, a non-stepped cylindrical mandrel or a stepped cubical mandrel may also be used, as well as other geometries such as hexagonal or octal. Furthermore, while particular types of mandrel substrates and substrate coatings have been disclosed, it will be understood that other mandrel substrates and substrate coatings can be used. For example, and not by way of limitation, while a titanium nitride coated molybdenum mandrel substrate has been disclosed, a titanium carbonitride coated molybdenum mandrel substrate may also be used, as well as a tungsten or titanium-zirconium-molybdenum alloy mandrel substrate. Moreover, while graphite has been described as the more diamond adhesive material, it will be appreciated that other outer "ring" materials may be used so long as the material has a greater adhesion to the diamond film than the central surface upon which the diamond wafer portion of the diamond film is formed upon. In addition, while it is preferable to coat exposed surfaces of the graphite with a protective silicon carbide base paint, it will be appreciated that other protective coatings and paints may be used, and that no protective coating or paint is required. Also, while a circular graphite ring is preferred, it will be recognized that the graphite may have almost any ring shape, e.g., square and triangular. Furthermore, while the upper surface of the graphite component is preferably generally coplanar with the upper surface of the TiN coated Mo component, it will be appreciated that the upper surface of the graphite component need not necessarily be coplanar, and that it may be angled relative to the upper surface of the TiN coated Mo component. In addition, while the graphite component is described as having an interference fit with the Mo component when both components are heated, it will be appreciated that the graphite component may be otherwise "close fit" with the Mo component. For example, and not by way of limitation, a graphite ring may be thread around a plateau of an Mo base, or a plug may be key locked or screwed to a graphite base. Any manner of holding the graphite component in relation to the Mo component during diamond film deposition shall be considered a "close fit" for purposes of the claims. Moreover, while particular configurations have been disclosed in reference to the dimensions of the two components of the mandrel, it will be appreciated that other configurations could be used as well. It will therefore be appreciated by those skilled in the art that yet other modifications could be made to the provided invention without deviating from its spirit and scope as so claimed.

## Claims

1. A mandrel for use in making a film of free-standing diamond, comprising:
a) a first component provided with a first upper surface having a first diamond bonding strength; and
b) a second component close fit to said first component when heated to a diamond film deposition temperature and provided with a second upper surface having a second diamond bonding strength which is greater than said first diamond bonding strength.

2. A mandrel according to claim 1, wherein:
said second upper surface is generally coplanar with said first upper surface.

3. A mandrel according to claim 1, wherein:
said second upper surface forms a perimeter around said first upper surface.

4. A mandrel according to claim 3, wherein:
said second component comprises graphite.

5. A mandrel according to claim 4, wherein:
said second component is provided with a silicon carbide base paint.

6. A mandrel according to claim 1, wherein:
said first component comprises molybdenum.

7. A mandrel according to claim 6, wherein:
said first component is coated with TiN.

8. A mandrel according to claim 7, wherein:
said second component comprises graphite.

9. A mandrel according to claim 7, wherein:
said second component is provided with a silicon carbide base paint.

10. A mandrel according to claim 1, wherein:
said first component has a stepped shape having a lower base with a shoulder, and a plateau provided with said first upper surface and a sidewall,
said second component has a ring shape, and
said second component is provided around said sidewall of said plateau and rests on said shoulder of said lower base.

11. A mandrel according to claim 10, wherein:
said second component has a thickness of approximately 0.125 - 0.750 inches.

12. A mandrel according to claim 10, wherein:
said first component has a stepped cylindrical shape, and said second component is a circular ring shape.

13. A mandrel according to claim 12, wherein:
said plateau has an outer diameter and said second component has an inner diameter approximately 0.001 inches greater than said outer diameter.

14. A mandrel according to claim 10, wherein:
said first and second components have first and second dimensions and are comprised of first and second materials, respectively, said first and second dimensions being such that when said first and second components are at room temperature, said second component may be placed around or removed from around said plateau, and said first and second materials each having respective coefficients of linear expansion such that when said first and second components are heated during a chemical vapor deposition process, said second component has an interference fit around said plateau of said first component.

15. A mandrel according to claim 1, wherein:
said second component has means for receiving said first component.

16. A mandrel according to claim 15, wherein:
said first component has a disc shape, and said second component is generally circular in shape and said means for receiving said first component is a circular recess in said second component.

17. A mandrel according to claim 16, wherein:
said first component has an outer diameter and said circular recess has an inner diameter approximately 0.001 inches greater than said outer diameter.

18. A mandrel according to claim 15, wherein:
said first and second components have first and second dimensions and are comprised of first and second materials, respectively, said first and second dimensions being such that when said first and second components are at room temperature, said first component can be placed in or retrieved from said means for receiving said second component, and said first and second materials each having respective coefficients of linear expansion such that when said first and second components are heated during a chemical vapor deposition process, said second first component has an interference fit with said second component.

19. A mandrel for use in making a film of free-standing diamond, comprising:
first and second deposition surfaces upon which diamond will be deposited as a film,
said first surface having a first diamond bonding strength,
said second surface comprising graphite, having a second diamond bonding strength greater than said first diamond bonding strength, and substantially forming a perimeter around said first surface.

20. A mandrel according to claim 19, wherein:
said first surface is titanium nitride.

21. A mandrel according to claim 20, wherein:
said first surface is coated with a protective coating.

22. A mandrel according to claim 21, wherein:
said protective coating is a silicon carbide base paint.

23. A mandrel according to claim 19, wherein:
said second surface being generally coplanar with said first surface.

24. An apparatus according to claim 23, wherein:
said second surface is 0.001 inches higher than said first surface.

25. A method of making a free standing diamond, comprising:
a) providing a mandrel having first and second components having first and second deposition surface, respectively, on which diamond is to be deposited as a film,
said first and second components being close fit together, and said first deposition surface having a first diamond bonding strength and said second deposition surface having a second diamond bonding strength greater than said first diamond bonding strength;
b) depositing diamond on the first and second surfaces of the mandrel to form a diamond film; and
c) removing said diamond film from the mandrel.

26. A method according to claim 25, wherein:
said second deposition surface is formed substantially as a perimeter around said first surface.

27. A method according to claim 25, wherein:
said second surface is generally coplanar with said first surface.

28. A method according to claim 25, wherein:
said step of providing a mandrel includes providing a mandrel with a titanium nitride first surface and a graphite second surface.

29. A method according to claim 28, wherein:
said first surface is provided with a silicon carbide coating.
